# EUROPEAN PATENT APPLICATION

(11) **EP 4 622 415 A1**
(43) Date of publication of application: **24.09.2025**
(21) Application number: 25162960.6
(22) Date of filing: 11.03.2025
(51) Int. Cl.: H10D 8/01, H10D 8/20, H10D 89/60

(54) **UNIDIRECTIONAL TRANSIENT VOLTAGE SUPPRESSOR DEVICE WITH LOW CLAMPING VOLTAGE**

(30) Priority: 22.03.2024 CN 202410338426
(71) Applicant: Littelfuse Semiconductor (Wuxi) Co., Ltd., Wuxi, Jiangsu 214142 (CN)
(72) Inventor: Zhang, Glenda, Wuxi, 214142 (CN); Zhou, Jifeng, Wuxi, 214142 (CN)
(74) Representative: Arnold & Siedsma

(57) **Abstract**

A transient voltage suppression (TVS) device, apparatus, structure and associated methods thereof. The TVS device includes a substrate, a first base layer, and a second base layer, the substrate coupled to the first base layer, and coupled to the second base layer, and one or more emitter layers formed in the first base layer.

## Description

### TECHNICAL FIELD

This disclosure relates generally to the field of power semiconductor discrete devices, and in particular, to transient voltage suppressor devices, such as for example, unidirectional transient voltage suppressor devices with low clamping voltage.

### BACKGROUND

Semiconductor devices such as transient voltage suppressor (TVS) devices are used to protect sensitive circuit nodes against one-time and time-limited overvoltage faults. Such TVS diodes are also used in modern high power IGBT circuits to protect against overload in the collector circuit. The requirements for such TVS diodes may include a high breakdown voltage, with low deviation and low temperature coefficient, as well as a high surge current capability, with a low clamping voltage. Moreover, in many applications TVS devices may be designed to protect against repetitive surge events, rendering the TVS devices susceptible to degradation after repetitive surge events. However, current unidirectional TVS devices are capable of providing low clamping voltage without degradation in performance.

### SUMMARY

The following summary is provided to introduce a selection of concepts in a simplified form that are further described below in the detailed description. This summary is not intended to identify key or essential features of the claimed subject matter, nor is it intended as an aid in determining the scope of the claimed subject matter.

The current subject matter relates to a transient voltage suppression device that may include a substrate, a first base layer, and a second base layer, the substrate coupled to the first base layer, and coupled to the second base layer, and one or more emitter layers formed in the first base layer.

The current subject matter may include one or more of the following optional features. The substrate may be a n-type substrate. The first base layer may be a p-base layer and the second base layer may be a N+-base layer.

A coupling of the substrate and the first base layer may be configured to form a first P-N junction. A coupling of the substrate and the second base layer may be configured to form a second P-N junction. One or more emitter layers are N+-type layers. Formation of one or more emitter layers in the first base layer may form a NPN configuration of the transient voltage suppression device.

One or more emitter layers may be disposed on a positive side of the transient voltage suppression device.

One or more emitter layers may be doped in the first base layer using one or more dopants. One or more dopants may include at least one of the following: phosphorous, boron, arsenic, gallium, and any combination thereof. One or more emitter layers may have a predetermined concentration of one or more dopants in the first base layer. One or more emitter layers may have a predetermined depth in the first base layer. The transient voltage suppression device may be characterized by a clamping voltage, where the clamping voltage of the transient voltage suppression device may be determined as a function of at least one of: a predetermined concentration of one or more dopants in the first base layer, a predetermined depth of one or more emitter layers in the first base layer, and any combinations thereof. Each of one or more emitter layers may have the same concentration of one or more dopants. Alternatively, or in addition, each of one or more emitter layers has a different concentration of one or more dopants. One or more emitter layers may be arranged in a predetermined pattern in the first base layer.

At least one of the substrate, the first base layer, and the second base layer may include at least one of: silicon, silicon carbide, silicon germanium, and any combination thereof.

The transient voltage suppression device may be a unidirectional transient voltage suppression device.

The current subject matter also relates to a method (e.g., a method for manufacturing a transient voltage suppression device). The method may include providing a substrate, a first base layer, and a second base layer, coupling the first base layer to the substrate via a first junction, and coupling the second base layer to the substrate via a second junction, and forming one or more emitter layers in the first base layer. Formation of one or more emitter layers in the first base layer may form a NPN configuration of a transient voltage suppression device. Further, the transient voltage suppression device may be characterized by a clamping voltage, where the clamping voltage of the transient voltage suppression device may be determined as a function of at least one of: a predetermined concentration of the one or more dopants in the first base layer, a predetermined depth of the one or more emitter layers in the first base layer, and any combinations thereof.

The details of one or more variations of the subject matter described herein are set forth in the accompanying drawings and the description below. Other features and advantages of the subject matter described herein will be apparent from the description and drawings, and from the claims.

### BRIEF DESCRIPTION OF THE DRAWINGS

The accompanying drawings, which are incorporated in and constitute a part of this specification, show certain aspects of the subject matter disclosed herein and, together with the description, help explain some of the principles associated with the present disclosure. In the drawings,
FIG. 1 illustrates an exemplary transient voltage suppressor (TVS) device;
FIG. 2 illustrates an exemplary unidirectional TVS device, according to the present disclosure. ;
FIGS. 3a-c illustrate various dopant layout configurations of emitter layer(s) in the first base layer, according to the present disclosure;
FIGS. 4a-b illustrate example current-voltage plots; and
FIG. 5 illustrates an exemplary process, according to the present disclosure.

The drawings are not necessarily to scale. The drawings are merely representations, not intended to portray specific parameters of the disclosure. The drawings are intended to depict exemples of the present disclosure and therefore, are not to be considered as limiting in scope. In the drawings, like numbering represents like elements.

Further, certain elements in some of the figures may be omitted, and/or illustrated not-to-scale, for illustrative clarity. Cross-sectional views may be in the form of "slices", and/or "near-sighted" cross-sectional views, omitting certain background lines otherwise visible in a "true" cross-sectional view, for illustrative clarity. Additionally, for clarity, some reference numbers may be omitted in certain drawings.

### DETAILED DESCRIPTION

Various approaches in accordance with the present disclosure will now be described more fully hereinafter with reference to the accompanying drawings. The devices, system(s), component(s), etc., may be embodied in many different forms and are not to be construed as being limited to the examples set forth herein. Instead, these examples are provided so this disclosure will be thorough and complete, and will fully convey the scope of the current subject matter to those skilled in the art.

To address these and potentially other deficiencies of currently available solutions, the disclosure relates to methods, systems, articles of manufacture, and the like that can, among other possible advantages, provide unidirectional transient voltage suppressor devices with low clamping voltage capable of providing an improved surge performance.

Voltage transients are defined as short duration surges of electrical energy and are the result of the sudden release of energy previously stored and/or induced by other means, such as, for example, heavy inductive loads, lightning, etc. Voltage transients may be classified into predictable or repeatable transients and random transients. In electrical or electronic circuits, this energy can be released in a predictable manner via controlled switching actions, or randomly induced into a circuit from external sources. Repeatable transients are frequently caused by the operation of motors, generators, and/or the switching of reactive circuit components. On the other hand, random transients are often caused by electrostatic discharge (ESD) and lightning, which generally occur unpredictably.

ESD is characterized by very fast rise times and very high peak voltages and currents, which may be the result of an imbalance of positive and negative charges between objects. ESD that is generated by everyday activities can surpass a vulnerability threshold of standard semiconductor technologies. In case of lightning, even though a direct strike is destructive, voltage transients induced by lightning are not the result of a direct strike. When a lightning strike occurs, the event can generate a magnetic field, which, in turn, can induce voltage transients of large magnitude in nearby electrical cables. For example, a cloud-to-cloud strike will affect not only overhead cables, but also buried cables. Even a strike 1 mile distant (1.6km) can generate 70 volts in electrical cables. In a cloud-to-ground strike, the voltage transient generating effect is significantly greater.

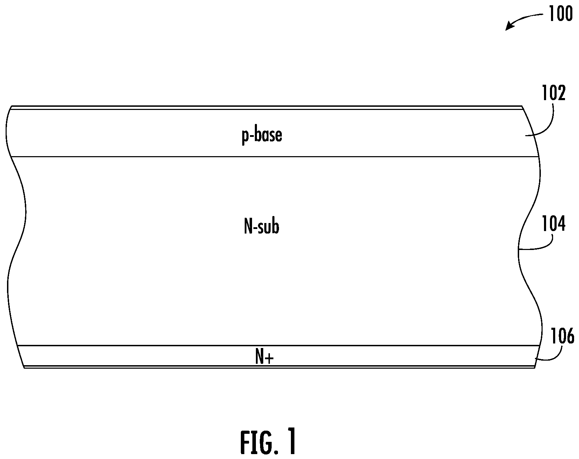

FIG. 1 illustrates atransient voltage suppressor (TVS) device 100. The device 100. The TVS device 100 can be formed in a monolithic semiconductor substrate, such as silicon. In particular, the TVS device 100 can include a substrate 104, a first base layer 102, and a second base layer 106. The substrate 104 can be formed having a polarity of a first type. The substrate 104 can be formed between the first base layer 102 and the second base layer 106. The first and second base layers 102, 106 can be formed having polarities of a second type and a third type, respectively. The second type polarity may be opposite to the first type polarity. As shown in FIG. 1, the substrate 104 can be an N-type substrate. The first base layer 102 can be a P-type base layer. The second base layer 106 can be N+-base layer.

The first base layer 102 can form a P-N junction with the substrate 104. The second base layer 106 can form another P-N junction with the substrate 104.

As can be understood, while FIG. 1a illustrates the device 100 being based upon a N-type substrate, the TVS device 100 can have a P-type substrate with N-type first and second base layers disposed on opposite surfaces. The TVS device 100 may be a unidirectional device, however, as can be understood, the TVS 100 may be any other type of device.

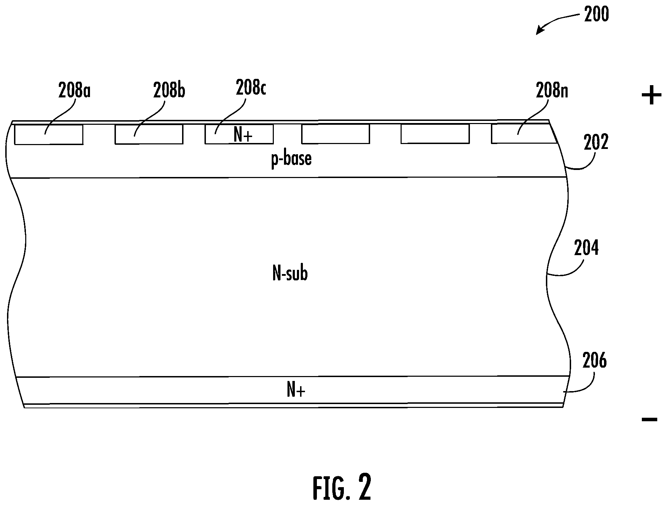

FIG. 2 illustrates a unidirectional TVS device 200, according to the present disclosure.. Similar to the device 100 shown in FIG. 1, the TVS device 200 may be configured to be formed in a semiconductor substrate, such as, for example, silicon. As can be understood, other substrate materials may be used. However, the device 200 may be configured to provide an advantageous structure, that may be helpful in providing a low clamping voltage while avoiding degrading of the surge performance of the TVS device, which may be useful in various industries, such as, for example, automotive applications.

To achieve the above advantages, the TVS device 200 may be configured to include one or more emitter layer(s) (e.g., N+ and/or P-based layer(s)). The TVS device 200 may be formed using a substrate (e.g., an N-substrate and/or a P-substrate). A base layer (e.g., a P-base and/or N-base) may formed on top of the substrate. The base layer may either be thermally doped into the substrate and/or epitaxially deposited (e.g., using P-type EPI). The emitter layer(s) may be doped into base layer and/or incorporated into the base layer using any other methods. The different layers in the TVS device may be configured to form different types of junctions. For example, the substrate and the base layers may form a PN portion, whereas addition of the emitter layer(s) may create an NPN portion, thereby making the TVS device 200 to be a combination of paralleled connections of PN type and NPN type devices.

During a negative surge pulse, the PN (i.e., substrate-base layer) portion may exhibit a high clamping voltage, while the NPN portion may exhibit a low clamping voltage due to current gain effect of transistor N+PN. The TVS device 200 configuration may allow tuning of the current gain of the transistor by adjusting different base layer's depth and/or concentration, which, in turn, may be configured to allow control of the clamping voltage of the TVS device 200.

During a positive surge pulse, due to low voltage drop (e.g., <1 Volt (V)), partial area covered by the emitter layer(s) may be enough to conduct a forward current. By tuning the ratio of emitter layer(s), the unidirectional TVS device 200 may be configured as a low clamping voltage device without sacrificing the surge performance.

Referring to FIG. 2, the TVS device 200 may include a first base layer 202 disposed on a positive side of the TVS device 200, a substrate 204, a second base layer 206 disposed on a negative side of the TVS device 200, and one or more emitter layer(s) 208 (a, b, c..., n) disposed on the positive side of the TVS device 200. The substrate 204 may be formed having a polarity of a first type. The first base layer 202 may be configured to have a polarity of a second type, which may be different from the polarity of the first type of the substrate 204. The second base layer 206 may have a polarity of a third type, which may or may not be different from the polarity of the substrate 204. The emitter layer(s) 208 may be formed in the first base layer 202. Each emitter layer(s) 208 may be configured to be separate layer(s) between in the first base layer 206. The polarity of the emitter layer(s) 208 may be similar to the polarity of the substrate 204 and/or the second base layer 206 and may be different from the polarity of the first base layer 202. Each emitter layer 208 may be doped into first base layer 202 and/or formed and/or incorporated into the first base layer 202 in any other way.

For example, as shown in FIG. 2a, the polarity of the substrate (e.g., polarity of the first type) may be N-type. The polarity of the first base layer 202 may be of P-type. The polarity of the second base layer 206 may be N+-type. The polarity of the emitter layer(s) 208 may be N+-type. As can be understood, other arrangements of polarities are possible. The substrate 204, the first and second base layers 202, 206 may be formed using silicon, silicon carbide, silicon germanium, and/or any other materials. The emitter layer(s) 208 may be formed using one or more dopants, such as, for example, phosphorous, boron, arsenic, gallium, and/or any other desired materials. Each emitter layer 208 may be formed using the same dopant materials and/or different dopant materials.

The combination of the polarities of the emitter layer(s) 208, the first base layer 202 and the substrate 204 may create a NPN configuration that may be conducive to creating a lower clamping voltage of the TVS device 200. The doping and/or depth of the emitter layer(s) 208 may be selected depending on a desired clamping voltage of the TVS device 200. The clamping voltage may be referred to as a voltage using which the TVS device 200 may be configured to conduct its fully rated current (e.g., hundreds of amperes, thousands of amperes, etc.). For example, an increase in doping concentration and/or depth of the emitter layer(s) 208 may be configured to decrease the clamping voltage of the TVS 200 and a decrease in the doping concentration and/or depth of the emitter layer(s) 208 may be configured to increase the clamping voltage of the TVS 200.

Alternatively, or in addition, the polarities and/or the depth/doping concentration of the emitter layer(s) 208 may be selected based on a desired breakdown voltage of the TVS device 200. The breakdown voltage may be referred to as the largest reverse voltage that may be applied without causing an exponential increase in leakage current in the TVS device 200. For example, a higher concentration of dopant in the emitter layer(s) 208 may cause the TVS device 200 to have a lower breakdown voltage; alternatively, a lower concentration of dopant in the emitter layer(s) 208 may cause the TVS device 200 to have a higher breakdown voltage. As can be understood, other relationships between dopant concentrations in the emitter layer(s) 208 and the breakdown voltage and/or the clamping voltage of the TVS device 200 are possible.

The dopant concentration in the emitter layer(s) 208 may be uniform. Alternatively, or in addition, the concentration may be non-uniform. This may allow for varying the clamping voltage of the TVS device 200. The emitter layer(s) 208 may also have a predetermined thickness. The thickness of the emitter layer(s) 208 may be less than the thickness of the substrate 204. The thickness of the emitter layer(s) 208 may also be less than the thickness of the first base layer 202.

Further, as can be understood, other types of doping of layers 204-206 and/or emitter layer(s) 208 (and/or any other components of the TVS device 200) are possible.

All layers 202-208 may be manufactured from the same material, e.g., silicon. Alternatively, or in addition, at least one of the layers 202-208 may be manufactured from different materials. The layers 202-208 may be configured to have same and/or different dopant materials and/or corresponding concentrations.

The emitter layer(s) 208 may be configured to form a P-N junction with the first base layer 202. Another P-N junction may be formed between the substrate layer 204 and the first base layer 202. The junctions may be configured to create a NPN configuration between the emitter layer(s) 208 (N+), the first base layer 202 (P), and the substrate 204 (N). As can be understood, any other concentration configurations may be possible (e.g., PNP, etc.).

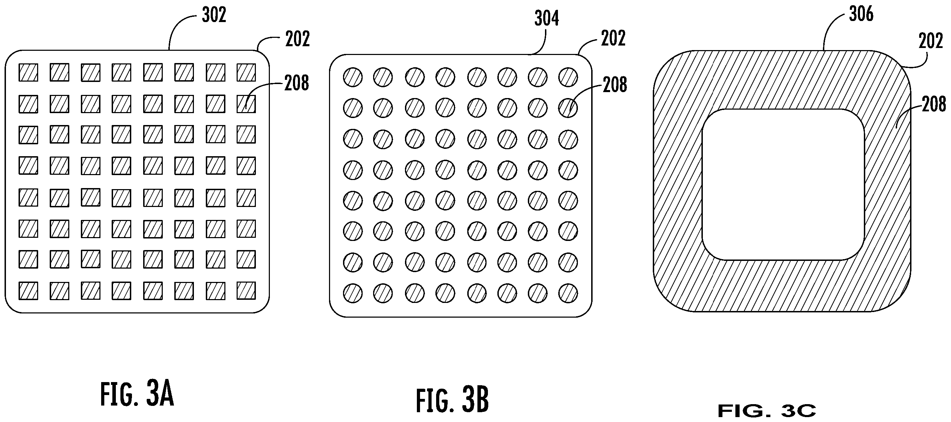

FIGS. 3a-c illustrate various dopant layout configurations of emitter layer(s) 208 in the first base layer 202, according to the present disclosure. For example, FIG. 3a shows a layout configuration 302, where each emitter layer 208 is arranged to have a square shape. FIG. 3b shows a layout configuration 304, where each emitter layer 208 is arranged to have a circular shape. FIG. 3c shows layer configuration 306, where the emitter layer 208 positioned around an edge of the first base layer 202. As can be understood, any desired dopant layout configurations are possible. The one or more emitter layer(s) 208 may be doped in and/or formed in the base layer 202 in the same and/or different configurations (e.g., circular, square, rectangular, etc.).

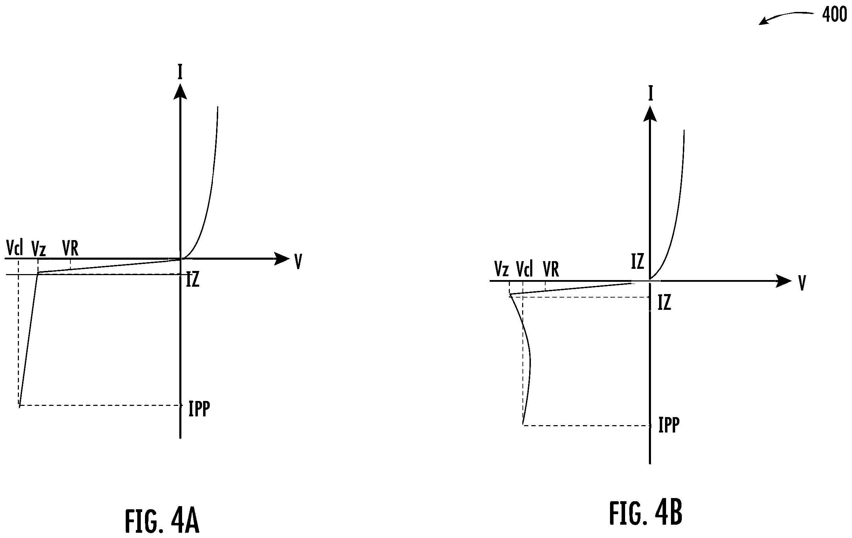

FIGS. 4a-b illustrate example current-voltage plots. FIG. 4a illustrates a plot 402 showing clamping voltage of an existing TVS device. FIG. 4b illustrates a plot 404 showing clamping voltage of the current subject matter's TVS device (e.g., TVS device 200 shown in FIG. 2). As shown in FIG. 4, the current subject matter's TVS device 200 has substantially reduced clamping voltage.

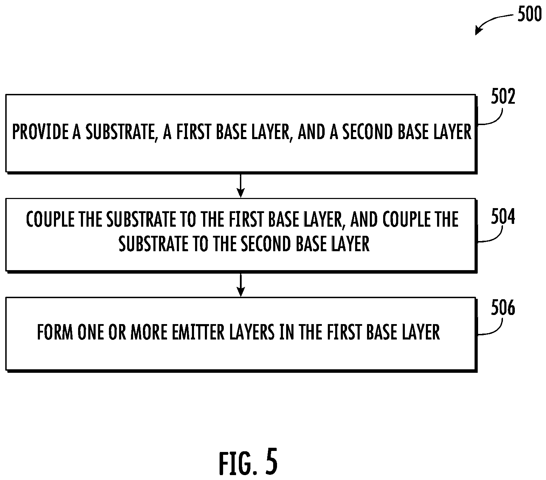

FIG. 5 illustrates an exemplary process 500 for manufacturing a transient voltage suppressor device, according to the present disclosure The process 500 may be used to manufacture, for example, TVS device 200 shown in FIG. 2.

At 502, a substrate, a first base layer, and a second base layer may be provided. For example, the substrate may be the substrate 204; the first base layer may be the first base layer 202; and the second base layer may be the second base layer 206. The substrate may be a n-type substrate. The first base layer may be a p-base layer and the second base layer may be N+-base layer.

At 504, the substrate may be coupled to the first base layer on one side (e.g., a positive side of the TVS device). The substrate may also be coupled to the second base layer on an opposite side (e.g., a negative side of the TVS device), as for example shown in FIG. 2. The substate may be configured to encompass and/or enclose at least a portion of each of the first and second base layers. Further, the coupling of the substrate and the first base layer may be configured to form a first P-N junction.

At 506, one or more emitter layers may be formed in the first base layer. For example, the emitter layers may include emitter layer(s) 208, as shown in FIG. 2. The emitter layers may be n-type layers, such as, for instance, N+ layers. The emitter layers may be any other type of layers and may be configured in accordance with specific arrangement and/or types of the substate and/or base layers, and/or specific applications and/or uses. The emitter layers may be doped in the first base layer and/or formed in the first base layer in any other way. The emitter layers may have a predetermined concentration of dopants and/or depth, one or more of which may be dependent on a desired clamping voltage. The dopants may include, but are not limited to, for example, phosphorous, boron, arsenic, gallium, and/or any other desired materials. Each emitter layer 208 may be formed using the same dopant materials and/or different dopant materials. The substrate, first and/or second base layers may include silicon, silicon carbide, silicon germanium, and/or any other materials.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

It is emphasized that the abstract of the disclosure is provided to allow a reader to quickly ascertain the nature of the technical disclosure. It is submitted with the understanding that it will not be used to interpret or limit the scope or meaning of the claims. In addition, in the foregoing detailed description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the detailed description, with each claim standing on its own as a separate embodiment. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects. Further, the use of "including," "comprising," or "having" and variations thereof herein is meant to encompass the items listed thereafter and equivalents thereof as well as additional items. Accordingly, the terms "including," "comprising," or "having" and variations thereof are open-ended expressions and can be used interchangeably herein.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the scope of the appended claims.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner and may generally include any set of one or more limitations as variously disclosed or otherwise demonstrated herein.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

The present disclosure is not to be limited in scope by the specific implementations described herein. Indeed, other various implementations of and modifications to the present disclosure, in addition to those described herein, will be apparent to those of ordinary skill in the art from the foregoing description and accompanying drawings. Thus, such other implementations and modifications are intended to fall within the scope of the present disclosure. Furthermore, the present disclosure has been described herein in the context of a particular implementation in a particular environment for a particular purpose. Those of ordinary skill in the art will recognize the usefulness is not limited thereto and the present disclosure may be beneficially implemented in any number of environments for any number of purposes. Thus, the claims set forth below are to be construed in view of the full breadth and spirit of the present disclosure as described herein.

## Claims

1. A transient voltage suppression device, comprising:
a substrate, a first base layer, and a second base layer, the substrate coupled to the first base layer, and coupled to the second base layer; and
one or more emitter layers formed in the first base layer.

2. The transient voltage suppression device according to claim 1, wherein the substrate is a n-type substrate.

3. The transient voltage suppression device according to claim 1 or 2, wherein the first base layer is a p-base layer and the second base layer is a N+-base layer.

4. The transient voltage suppression device according to any of the preceding claims, wherein a coupling of the substrate and the first base layer is configured to form a first P-N junction; and
a coupling of the substrate and the second base layer is configured to form a second P-N junction.

5. The transient voltage suppression device according to any of the preceding claims, wherein the one or more emitter layers are N+-type layers.

6. The transient voltage suppression device according to any of the preceding claims, wherein formation of the one or more emitter layers in the first base layer forms a NPN configuration of the transient voltage suppression device.

7. The transient voltage suppression device according to any of the preceding claims, wherein the one or more emitter layers are disposed on a positive side of the transient voltage suppression device,
and/or
wherein the one or more emitter layers are doped in the first base layer using one or more dopants, preferably
wherein the one or more dopants include at least one of the following: phosphorous, boron, arsenic, gallium, and any combination thereof, more preferably
wherein the one or more emitter layers have a predetermined concentration of the one or more dopants in the first base layer.

8. The transient voltage suppression according to any of the preceding claims, wherein the one or more emitter layers have a predetermined depth in the first base layer.

9. The transient voltage suppression according to claim 7 or 8, wherein a clamping voltage of the transient voltage suppression device is determined as a function of at least one of: a predetermined concentration of the one or more dopants in the first base layer, a predetermined depth of the one or more emitter layers in the first base layer, and any combinations thereof.

10. The transient voltage suppression according to any of the claims 7-9, wherein each of the one or more emitter layers has the same concentration of the one or more dopants.

11. The transient voltage suppression according to any of the claims 7-9, wherein each of the one or more emitter layers has a different concentration of the one or more dopants.

12. The transient voltage suppression according to any of the preceding claims, wherein the one or more emitter layers are arranged in a predetermined pattern in the first base layer.

13. The transient voltage suppression device according to any of the preceding claims, wherein at least one of the substrate, the first base layer, and the second base layer include at least one of: silicon, silicon carbide, silicon germanium, and any combination thereof.

14. The transient voltage suppression device according to any of the preceding claims, wherein the transient voltage suppression device is a unidirectional transient voltage suppression device.

15. A method, comprising:
providing a substrate, a first base layer, and a second base layer;
coupling the first base layer to the substrate via a first junction, and couple the second base layer to the substrate via a second junction; and
forming one or more emitter layers in the first base layer;
wherein formation of the one or more emitter layers in the first base layer forms a NPN configuration of a transient voltage suppression device;
wherein the transient voltage suppression device is **characterized by** a clamping voltage, where the clamping voltage of the transient voltage suppression device is determined as a function of at least one of: a predetermined concentration of the one or more dopants in the first base layer, a predetermined depth of the one or more emitter layers in the first base layer, and any combinations thereof.
